# EUROPEAN PATENT APPLICATION

(11) **EP 4 451 353 A1**
(43) Date of publication of application: **23.10.2024**
(21) Application number: 23915171.5
(22) Date of filing: 30.05.2023
(51) Int. Cl.: H01L 31/18, H01L 31/05, H01L 21/683

(54) **PHOTOVOLTAIC STRESS-FREE INTERCONNECTION APPARATUS, USE METHOD AND ASSEMBLY**

(30) Priority: 22.02.2023 CN 202310172815; 23.02.2023 CN 202320387547 U; 07.03.2023 CN 202320471804 U; 20.03.2023 CN 202320573073 U
(71) Applicant: Zhejiang Znergy Solar Co., Ltd., Hangzhou, Zhejiang 310000 (CN)
(72) Inventor: DENG, Shifeng, Hangzhou, Zhejiang 310000 (CN); SHI, Lei, Hangzhou, Zhejiang 310000 (CN)
(74) Representative: Chimini, Francesco
(86) International application number: PCT/CN2023/097158
(87) International publication number: WO 2024/174404

(57) **Abstract**

The present invention discloses a photovoltaic stress-free interconnection device, which includes a body. An interconnect wire coil configured for releasing an interconnect wire is arranged on a left side of the body. An interconnect wire cutter cutting the interconnect wire is arranged on an upper side of the interconnect wire coil. An interconnect wire blade is connected to a cylinder that telescopes up and down. A feeding mechanism transmitting the cell pieces is arranged on one side of the interconnect wire cutter, and a workbench configured for placing the cell pieces is arranged on the body. A conveying mechanism moving the cell pieces to the right is arranged on the workbench. The conveying mechanism moves the cell entirely to the right by one station, thus facilitating the addition of the next cell piece. The device further includes a drawing mechanism that pulls out and wraps the interconnect wire on the cell pieces, and a wrapping mechanism that fixes the interconnect wire on the cell pieces. The drawing mechanism pulls out the interconnect wire, and the wrapping mechanism pulls out the adhesive tape and fixes the interconnect wire onto the cell piece.

## Description

### CROSS-REFERENCE TO RELATED APPLICATION

The present invention claims priority to the Chinese patent application with the filing No. 2023101728157, titled "PHOTOVOLTAIC STRESS-FREE INTERCONNECTION DEVICE, USE METHOD AND ASSEMBLY", filed with the Chinese Patent Office on February 22, 2023; the Chinese patent application with the filing No. 2023203875476, titled "CELL WRAPPING MECHANISM AND ASSEMBLY PRODUCED BY SAME", filed with the Chinese Patent Office on February 23, 2023; the Chinese Patent Application with the filing No. 2023204718044, titled " CELL UPPER-SIDE WRAPPING MECHANISM AND ASSEMBLY PRODUCED BY SAME", filed with the Chinese Patent Office on March 7, 2023; and the Chinese patent application with the filing No. 2023205730734, titled "DOUBLE-SIDED SOLDER-STRIP WRAPPING MECHANISM AND PHOTOVOLTAIC ASSEMBLY PRODUCED BY SAME", filed with the Chinese Patent Office on March 20, 2023, the contents of which are incorporated herein by reference in entirety.

### TECHNICAL FIELD

The present invention relates to the field of photovoltaic assembly productions, and particularly to a photovoltaic stress-free interconnection device, a use method, and an assembly.

### BACKGROUND ART

In photovoltaic power generation, photovoltaic assemblies function to receive sunlight and convert it into electrical energy. In practical applications, batteries are not monolithic but are spliced from multiple cell pieces to ensure the output power of the assembly. Multiple cell pieces are connected by interconnect wires. The interconnect wire includes a copper base material located on the inside and a solder alloy layer located on the outside, where the solder alloy has a low melting point and is easy to melt. However, neither the solder alloy nor the copper can connect well with the cell itself, where the adhesion is low. Therefore, the traditional approach is to lay silver paste (also known as the busbar) on the cell and place the interconnect wire on the busbar. The solder alloy in the interconnect wire can better fuse with the busbar, thereby enhancing the bond strength. However, the problem is that silver paste is relatively expensive, accounting for a significant proportion of the production cost of cell assemblies, almost over 20%. Thus, how to reduce the usage of silver paste while ensuring power generation efficiency and connection strength, thereby reducing production costs, is an urgent problem that needs to be solved by those skilled in the art.

### SUMMARY

The objective of the present invention is to provide a photovoltaic stress-free interconnection device, a use method, and an assembly to at least solve the problems presented in the background art mentioned above.

To achieve the above objective, some embodiments of the present invention provide a photovoltaic stress-free interconnection device, including a body. An interconnect wire disc (also called an interconnect wire coil) configured for releasing the interconnect wire is arranged on the left side of the body. An interconnect wire cutter cutting the interconnect wire is arranged on the upper side of the interconnect wire disc. A feeding mechanism configured for transmitting cell pieces is arranged on one side of the interconnect wire cutter, and a workbench configured for placing the cell pieces is arranged on the body. A conveying mechanism moving the cell pieces to the right is arranged on the workbench. A drawing mechanism that pulls out and wraps the interconnect wire on the cell pieces, and a wrapping mechanism that fixes the interconnect wire on the cell pieces are further included.

In the above implementation, wrapping is performed from the upper and lower sides of the cell to achieve the fixation of the interconnect wire and the adhesive tape, thereby integrating processing, and improving efficiency. Interconnection at normal temperature avoids cell warping and prevents cell piece fragments caused by uneven temperature, thus improving the yield rate; normal temperature interconnection avoids the power consumption caused by infrared welding, thus saving costs. Using stress-free interconnection technology, flux is no longer used, thus reducing costs, improving reliability, and being more environmentally friendly.

In some optional embodiments, the interconnect wire is a composite interconnect wire, wherein the composite interconnect wire is formed by an interconnect wire and an adhesive tape arranged on the interconnect wire.

In some optional embodiments, multiple adhesive tapes are arranged at equal intervals on one side of the interconnect wire, and the adhesive tapes are adhered to the interconnect wire through adhesive surfaces, with the spacing between two adjacent adhesive tapes corresponding to the width of the cell piece.

In the above implementation, the composite interconnect wire is used, and an adhesive tape sheet is directly adhered to a lower side of the interconnect wire at a first station. Thus, the need for wrapping from a lower side is eliminated, and only wrapping from an upper side is required. This saves one wrapping mechanism, thus reducing costs.

In some optional embodiments, the composite interconnect wire includes an interconnect wire and adhesive tapes arranged at equal intervals along a length direction of the interconnect wire on both opposite sides of the interconnect wire. Two adhesive tapes adjacent to each other along the length direction of the interconnect wire are alternately arranged on two opposite sides of the interconnect wire. The adhesive surfaces of the two adjacent adhesive tapes are opposite to each other in a direction transverse to the length direction. Additionally, adjacent inner-ring adhesive tapes and outer-ring adhesive tapes of the composite interconnect wire, wound on the interconnect wire disc, can be connected by a release paper.

In the above implementation, the composite interconnect wire includes an interconnect wire and adhesive tapes arranged on both opposite sides of the interconnect wire, thus eliminating the need for adhering the adhesive or wrapping and allowing direct pressing. This simplifies the process and reduces costs. There is no need for lower-side pressing or wrapping, making it more convenient and saving lower-side device.

In some optional embodiments, the feeding mechanism is a manipulator, which is capable of rotating and moving up and down and is provided with a first suction cup at the lower end.

The conveying mechanism includes a suction device capable of driving the cell pieces to move up and down and left and right. In some optional embodiments, multiple second suction cups are arranged at the lower end of the suction device.

In some optional embodiments, the drawing mechanism includes a left clamping jaw arranged on the right side of the interconnect wire disc and a right clamping jaw capable of moving up and down and left and right, arranged on the right side of the interconnect wire disc. The interconnect wire is pulled out and straightened by the right clamping jaw after passing through inside of the left clamping jaw. The right clamping jaw is mounted on the body.

In some optional embodiments, a support plate capable of moving left and right and up and down is arranged between the interconnect wire disc and the right clamping jaw. A guide groove guiding the interconnect wire is arranged on the support plate. The left clamping jaw is mounted at an end portion of the guide groove. The arrangement of the support plate, which is able to work in combination with the right clamping jaw and the left clamping jaw, enables better wrapping.

In some optional embodiments, the wrapping mechanism includes two rollers that can move up and down, left and right, and rotate, with adhesive tapes wound around them. The upper side and lower side of the workbench are respectively arranged with the rollers. A pressing cylinder, parallel to the roller and configured for pressing the adhesive tape, is also arranged on the left side of the roller. The workbench extends to the left to form an overhanging frame that supports the front and rear sides of the bottom of the cell piece, and the wrapping mechanism is also provided with an adhesive tape cutter configured for cutting off the adhesive tape.

In some optional embodiments, the wrapping mechanism further includes a roller arranged on the body and wound by adhesive tape, which can move left and right, and up and down; and a support frame that supports the roller. A pressing cylinder capable of moving up and down is also mounted on the left side of the roller on the support frame. An adhesive tape cutter capable of cutting off the adhesive tape is also arranged on the support frame.

In some optional embodiments, the wrapping mechanism includes two pressing cylinders, and the adhesive tape cutter is located between the two pressing cylinders.

In some optional embodiments, the pressing cylinder of the two pressing cylinders, which is relatively remote from the interconnect wire disc in a longitudinal extension direction of the body, is made of a rubber material with elasticity, so as to press the adhesive tape against the support frame.

In some optional embodiments, the wrapping mechanism includes left and right rollers wound by adhesive tapes, and the adhesive surfaces of the adhesive tapes on the two rollers are opposite. The wrapping mechanism also includes a power mechanism that drives the roller to move up and down and left and right, and a pressing cylinder mounted on the left side of the roller in a manner of rotating. The adhesive tape cutter is located on the left side of the pressing cylinder.

In some optional embodiments, the power mechanism includes a vertical cylinder capable of moving and telescoping vertically, and a horizontal cylinder connected to the vertical cylinder and capable of telescoping horizontally. The roller is mounted on a telescopic end of the horizontal cylinder.

In some optional embodiments, a secondary rolling mechanism is arranged on the left side of the pressing cylinder.

In some optional embodiments, the secondary rolling mechanism includes a pressing ring arranged on the left side of the pressing cylinder for pressing the adhesive tape.

In some optional embodiments, multiple pressing rings are provided, and the number of pressing rings corresponds to that of the adhesive tapes.

In some optional embodiments, the wrapping mechanism includes a pressing cylinder and a power mechanism that drives the pressing cylinder to move up and down and left and right.

In some optional embodiments, the power mechanism includes a vertical electric push rod capable of telescoping vertically, and a horizontal electric push rod connected to the vertical electric push rod and capable of telescoping horizontally. The pressing cylinder is mounted on a telescopic end of the horizontal electric push rod.

In some optional embodiments, an adhesive tape groove guiding the adhesive tape is arranged on the roller along the circumferential direction of the roller.

In some optional embodiments, the photovoltaic stress-free interconnection device further includes an adsorption mechanism mounted on the workbench and configured for absorbing the adhesive tape.

In some optional embodiments, the adsorption mechanism includes a plate body with a hollow inner cavity and adsorption holes evenly arranged on an upper end of the plate body, wherein a lower end of the plate body is connected to a negative pressure pipeline.

In some optional embodiments, one side of the interconnect wire disc is arranged with a pressing plate closely abutting the composite interconnect wire in an elastic manner. A release film is arranged at an end of the pressing plate in contact with the adhesive tape.

In some optional embodiments, the photovoltaic stress-free interconnection device further includes a release paper winding mechanism arranged on one side of the interconnect wire disc.

In some optional embodiments, the release paper winding mechanism includes a winding drum and a motor connected to the winding drum.

Some embodiments of the present invention provide a use method for a photovoltaic stress-free interconnection device, comprising the following steps:
laying an interconnect wire for a first cell piece, wherein the right clamping jaw pulls the interconnect wire in the left clamping jaw to the right, wherein a length is a width of one cell piece plus a length of an electrode, for easy connection; at the same time, the left end of the interconnect wire is a little less to the edge of the cell; cutting by the interconnect wire cutter and then clamped by the left clamping jaw, such that the interconnect wire is straightened;
attaching the interconnect wire to the first cell piece, wherein a manipulator transfers the first cell piece from a conveyor belt to an overhanging frame on a left side of a workbench, which is a first station, and the first cell piece is pressed downwards to contact the interconnect wire on the lower side;
performing wrapping (wrapping wire) on the lower side of the cell piece, wherein the lower roller moves upwards, the interconnect wire is fixed to the cell piece with adhesive tape, and the adhesive tape is affixed from right to left; then, the left clamping jaw releases the interconnect wire, the support plate moves to the left, and the roller continues to move; after affixing, the adhesive tape is cut by the adhesive tape cutter, the roller returns to an initial position, the support plate returns to an initial position, the left clamping jaw releases, and the manipulator moves away;
placing the cell piece, wherein a suction device moves the cell piece to the right onto the workbench, which is a second station;
laying the interconnect wire, wherein the right clamping jaw grabs the interconnect wire and moves it to the right, then the interconnect wire cutter cuts the interconnect wire to a length corresponding to a distance between the first station and the second station; a left end of the interconnect wire does not reach a left end of the cell, making it easy to leave a distance, and a right end does not reach a right end of the right cell, also making it easy to leave a distance; there will be a bend in the center to form a "Z" shape, making it easier to connect the two batteries; therefore, a length of the right clamping jaw grip for gripping corresponds to the length and can be adjusted in practice as required; then the left clamping jaw clamps tightly and the interconnect wire is straightened, wherein a right-side part of the interconnect wire is located on the upper side of the cell piece in the second station; then the manipulator again takes the cell piece and places it in the first station and on the upper side of the interconnect wire;
performing wrapping on the upper side of the cell piece, wherein the upper roller adheres the adhesive tape to the upper side of the cell piece at the second station; the roller moves to the left, then down and to the right after the adhesive tape has been adhered; when approaching the tail portion of the cell piece, the right clamping jaw releases and moves to the right to avoid; after the adhesion is completed, the adhesive tape is cut off by an adhesive tape cutter, and the above step of performing wrapping on the lower side of the cell piece is repeated;
moving the cell horizontally, wherein the suction device moves the cell pieces from the first station and second station to the right by one station, then the above step of laying the interconnect wire continues and the subsequent steps are performed, cycling until the set last cell piece is reached; and
assembling the last cell piece, wherein, after attaching the adhesive tape to the lower side of the last cell piece at the first station, the manipulator moves away; under the action of the suction device, the cell piece on its right side is moved to the right by one station and then reaches the second station, and the suction device moves away; the right clamping jaw pulls an interconnect wire with a length of one station plus a length of an electrode; the interconnect wire cutter cuts the interconnect wire, the left clamping jaw clamps tightly, and the support plate and the right clamping jaw move to the right together, so as to adhere the interconnect wire to the surface of the cell; the upper roller adheres the adhesive tape to the upper side of the cell piece at the second station; the roller moves to the left, then down and to the right after the adhesive tape has been adhered; when approaching the tail portion of the cell piece, the right clamping jaw releases and moves to the right to avoid; after the adhesion is completed, the adhesive tape is cut off by an adhesive tape cutter.

Some embodiments of the present invention provide an assembly produced using the photovoltaic stress-free interconnection device, comprising a cell piece, an interconnect wire arranged on the cell piece, and an adhesive tape fixing the interconnect wire to the cell piece. The adhesive tape wraps around the interconnect wire from the outside and is fixed to the cell piece.

### BRIEF DESCRIPTION OF DRAWINGS

FIG. 1 shows a main view of a photovoltaic stress-free interconnection device provided by some embodiments of the present invention;
FIG. 2 shows an axonometric drawing of the photovoltaic stress-free interconnection device provided by some embodiments of the present invention;
FIG. 3 shows an axonometric drawing of a roller of the photovoltaic stress-free interconnection device provided by some embodiments of the present invention;
FIG. 4 shows a schematic diagram of a connection between an interconnect wire and an adhesive tape provided by some embodiments of the present invention;
FIG. 5 shows a main view of a photovoltaic stress-free interconnection device provided by some other embodiments of the present invention;
FIG. 6 shows an axonometric drawing of a connection between a roller and a workbench of the photovoltaic stress-free interconnection device provided by some other embodiments of the present invention;
FIG. 7 shows a first axonometric drawing of the roller of the photovoltaic stress-free interconnection device provided by some other embodiments of the present invention;
FIG. 8 shows a second axonometric drawing of the roller of the photovoltaic stress-free interconnection device provided by some other embodiments of the present invention;
FIG. 9 shows a schematic view of a structure of a plate body of the photovoltaic stress-free interconnection device provided by some other embodiments of the present invention;
FIG. 10 shows a schematic view of a structure of the photovoltaic stress-free interconnection device provided by some other embodiments of the present invention;
FIG. 11 shows an axonometric drawing of the photovoltaic stress-free interconnection device provided by some other embodiments of the present invention;
FIG. 12 shows an axonometric drawing of a connection between the interconnect wire and the adhesive tape of the photovoltaic stress-free interconnection device provided by some other embodiments of the present invention;
FIG. 13 shows a schematic view of a structure of a plate body of the photovoltaic stress-free interconnection device provided by some other embodiments of the present invention;
FIG. 14 shows a schematic diagram of a connection between a pressing cylinder and a vertical electric push rod of the photovoltaic stress-free interconnection device provided by some embodiments of the present invention;
FIG. 15 shows a schematic diagram of a structure of a composite interconnect wire after winding provided by yet some more embodiments of the present invention;
FIG. 16 shows a flowchart of a use method for the photovoltaic stress-free interconnection device provided by some embodiments of the present invention; and
FIG. 17 shows an assembly produced using the photovoltaic stress-free interconnection device provided by some embodiments of the present invention.

In the figure: 1- body; 2- interconnect wire cutter; 3- workbench; 4- manipulator; 5- suction device; 6- left clamping jaw; 7- right clamping jaw; 8- support plate; 9- guide groove; 10- roller; 11- pressing cylinder; 12- adhesive tape cutter; 13- cell piece; 14- interconnect wire; 15- adhesive tape; 22- interconnect wire disc; 25- plate body; 26- adsorption hole; 28- vertical cylinder; 29-horizontal cylinder; 21- pressing ring; 30- vertical electric push rod; 31- horizontal electric push rod; 32- support plate; 33- pressing plate; 34- winding drum; 37- plate body.

### DETAILED DESCRIPTION OF EMBODIMENTS

The technical solutions in the embodiments of the present invention will be clearly and completely described below in conjunction with the drawings in the embodiments of the present invention. Obviously, the described embodiments are only a part of the embodiments of the present invention, and not all of the embodiments. Based on the embodiments in the present invention, all other embodiments obtained by those of ordinary skill in the art without making inventive efforts are within the scope of protection of the present invention.

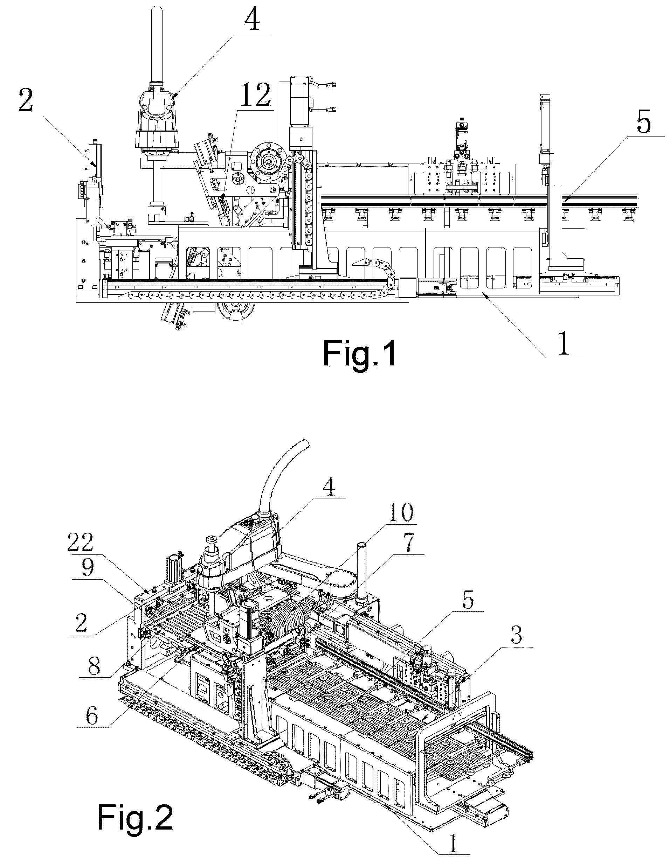

In the description of some embodiments of the present invention, it should be noted that the orientation or position relationships indicated by the terms such as "up", "down", "left", "right", "inside" and "outside" are the orientation or position relationships shown based on the drawings, or the orientation or position relationships customarily placed in the use of the product of the present invention. It is only for the convenience of describing the present invention and simplifying the description, and does not indicate or imply that the device or element referred to must be in a specific orientation or be constructed and operated in a specific orientation, and thus should not be construed as limiting the present invention. For example, in some embodiments of the present invention, along a length extension direction of the body of the device (referring to FIG. 1, where the direction from the component indicated by reference numeral 2 towards the component indicated by reference numeral 5 can be referred to as the length extension direction or lengthwise extension direction of the body), the component indicated by reference numeral 2 is located on the "left side" of the body. Correspondingly, the component indicated by reference numeral 5 is located on the "right side" of the body. In another example, in some embodiments of the present invention, along the vertical direction perpendicular to the length extension direction of the body of the device, an assembly or component located at a relatively higher level is positioned on the "upper side" of an assembly or component located at a relatively lower level.

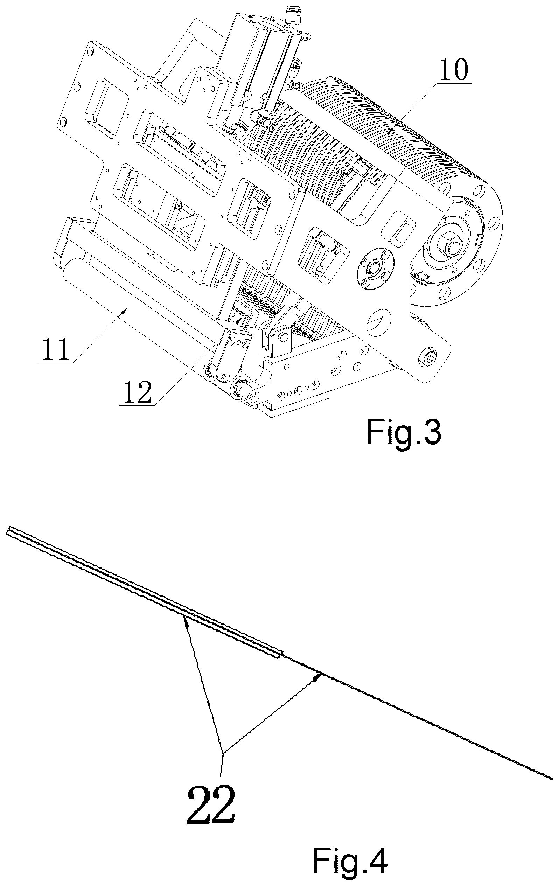

Referring to FIGS. 1 to 3, the photovoltaic stress-free interconnection device is provided by some embodiments of the present invention. The photovoltaic stress-free interconnection device includes a body 1, wherein the body 1 can include an entire support frame and a bottom support structure. An interconnect wire coil 22 (also called an interconnect wire disc) configured for releasing the interconnect wire is arranged on the left side of the body 1. An interconnect wire cutter 2 cutting the interconnect wire is arranged on the upper side of the interconnect wire coil (interconnect wire disc) 22. The interconnect wire cutter 2 is connected to a cylinder that can be telescoped up and down. A feeding mechanism configured for transmitting the cell pieces is arranged on one side of the interconnect wire cutter 2. In the embodiments of the present invention, the feeding mechanism can be a manipulator 4, which is capable of rotating and moving up and down, with a first suction cup at its lower end. The manipulator 4 can rotate, which uses the first suction cup to suction the cell pieces. In other words, the manipulator picks and places the cell pieces through the air-suction and air-releasing from the first suction cup. A workbench 3 configured for placing the cell pieces is arranged on the body 1. A conveying mechanism moving the cell pieces to the right is arranged on the workbench 3. The conveying mechanism moves the cell entirely to the right by one station, thus facilitating the addition of the next cell piece.

The conveying mechanism includes a suction device 5 capable of driving the cell pieces to move up and down and left and right. Multiple second suction cups are arranged at the lower end of the suction device 5. The suction device 5 can be connected to a cylinder or lead screw motor capable of telescoping left and right so as to realize the left-and-right movement. Additionally, the suction device 5 can also be fitted, in an up-and-down direction, with a cylinder or lead screw motor that telescopes up and down, so as to realize the up-and-down movement.

The photovoltaic stress-free interconnection device provided in some embodiments of the present invention further includes a drawing mechanism that pulls out and wraps the interconnect wire on the cell pieces, and a wrapping mechanism that fixes the interconnect wire on the cell pieces. The drawing mechanism can pull out the interconnect wire, and the wrapping mechanism can pull out the adhesive tape and fix the interconnect wire onto the cell piece.

In some embodiments of the present invention, the drawing mechanism can include a left clamping jaw 6 arranged on the inside (or called the right side) of the interconnect wire coil 22 and a right clamping jaw 7 that can move up, down, left, and right. The interconnect wire is pulled out and straightened by the right clamping jaw 7 after passing through inside of the left clamping jaw 6. The right clamping jaw 7 is mounted on the body 1. The number of right clamping jaws 7 corresponds to the number of interconnect wires. The right clamping jaw 7 can be electromagnetic for opening and closing. The right clamping jaw 7 can also be mechanical, using a linkage to open, which is entirely connected to a cylinder or lead screw motor that telescopes from left to right, and fitted, in an up-and-down direction, with a cylinder or lead screw motor that telescopes up and down. The left clamping jaw 6 can be electromagnetic, or it can be mechanical, which provides a structure similar to the right clamping jaw 7.

A support plate 8 capable of moving left and right can be provided at one end of the interconnect wire coil 22 near the workbench 3. The support plate 8 can be provided with a guide groove guiding the interconnect wire, and the left clamping jaw 6 can be mounted on the end portion of the guide groove 9. The lower side of the support plate 8 can be connected to a cylinder or lead screw motor capable of telescoping up and down.

In some embodiments of the present invention, the wrapping mechanism includes two rollers (also called the track rollers) 10 that can move up and down, left and right, and rotate, with adhesive tapes wound around them. Two rollers 10 are provided, which are respectively positioned on the upper side and lower side of the workbench 3. A pressing cylinder 11, parallel to the roller and configured for pressing the adhesive tape, is arranged on a side of the roller 10. The pressing cylinder 11 here can be individually connected to a cylinder that moves up and down. The workbench 3 extends to the left to form an overhanging frame that supports the front and rear sides of the bottom of the cell piece. The wrapping mechanism further includes an adhesive tape cutter 12, provided on one side of the roller 10 and cutting off the adhesive tape. The middle of the overhanging frame is hollow, with front and rear sides providing support for the bottom, thus allowing the adhesive tape to adhere to the lower side of the cell piece. The overhanging frame is the first station, and a second station is set on the workbench 3. The adhesive tape cutter 12 can include a blade and a cylinder that drives the blade to extend and retract. The roller 10 can be mounted on a mounting bracket. The mounting bracket can be connected to a cylinder or lead screw motor capable of telescoping up and down, and a fitted cylinder or lead screw motor capable of telescoping left and right. Left and right pressing cylinders 11 can be provided and the adhesive tape cutter 12 can be located between the two pressing cylinders 11. The extruding effect achieved by the two pressing cylinders 11 is better. To prevent the end portion of the adhesive tape from wobbling, the inner pressing cylinder 11 can closely abut the mounting bracket of the roller 10 in an elastic manner, and the pressing cylinder 11 can be connected to a motor to drive it. It is important to note that the end in contact with the adhesive surface of the adhesive tape applies a release paper or a material to which the adhesive surface does not adhere. An adhesive tape groove guiding the adhesive tape is arranged on the roller 10.

The body 1 is also provided with a central processor, which is configured to control all electrical components, thus achieving unified control.

Referring to FIGS. 1 to 4, the photovoltaic stress-free interconnection device (or called cell wrapping mechanism) is provided by some other embodiments of the present invention. The photovoltaic stress-free interconnection device includes an interconnect wire disc (interconnect wire coil) 22 mounted at the left end of the body 1. The body 1 is also provided with a processor connected to various electrical actuators. An interconnect wire is wound on the interconnect wire disc 22, with adhesive tape sheets arranged at equal intervals on the lower side of the interconnect wire. A spacing between two adhesive tape sheets corresponds to the width of the cell. The adhesive tape sheets and the interconnect wire form therebetween a composite interconnect wire. An interconnect wire cutter 2 cutting off the composite interconnect wire is arranged on a side of the interconnect wire disc 22. The interconnect wire cutter 2 includes an interconnect wire cutting blade, and a cylinder or lead screw motor connected to the interconnect wire cutting blade.

The body 1 is also mounted with a drawing mechanism (or traction mechanism) pulling out the composite interconnect wire and a wrapping mechanism (or adhesive applying mechanism) adhering the adhesive tape from the upper side to the cell piece. The drawing mechanism pulls the interconnect wire, and the wrapping mechanism performs the adhesion. The drawing mechanism includes a right clamping jaw 7, mounted on the frame 1 and capable of moving up, down, left, and right. The right clamping jaw 7 is located on the right side of the interconnect wire disc 22. The right clamping jaw 7 is connected to a cylinder or lead screw motor on the right side, and the right clamping jaw 7 can be electromagnetic or mechanical, similar to scissors to open and close. The wrapping mechanism includes a roller 10, which is mounted on the body 1, located on the workbench and the corresponding upper side of the body, capable of moving left and right and up and down, and wound by an adhesive tape; and a support frame (also referred to as a mounting bracket) which supports the roller 10. A pressing cylinder 11 capable of moving up and down is also mounted on the left side of the roller 10 on the support frame. The upper end of the pressing cylinder 11 can be connected with a cylinder capable of telescoping up and down, and the pressing cylinder 11 presses the affixed adhesive tape. An adhesive tape cutter 12 capable of cutting off the adhesive tape is also arranged on the support frame. The adhesive tape cutter 12 can include an adhesive tape blade, and a cylinder or lead screw motor connected driving the adhesive tape blade to cut.

Left and right pressing cylinders 11 can be provided and the adhesive tape cutter 12 is located between the two pressing cylinders 11. This makes the pressing effect better. The inner pressing cylinder 11 is made of a rubber material with elasticity to press the adhesive tape against the support frame, thus preventing the end of the adhesive tape from loosening. An adhesive tape groove guiding the adhesive tape is arranged on the roller 10 in a circumferential direction.

A support plate 8 capable of moving left and right and up and down is arranged between the interconnect wire disc 22 and right clamping jaw 7. A guide groove guiding the composite interconnect wire is arranged on the support plate 8. The left clamping jaw 6 is mounted at an end portion of the guide groove. The left clamping jaw 6 can clamp the interconnect wire. Additionally, a platform that can be moved left and right in combination with up and down can be further included, wherein the left clamping jaw 6 is mounted on the platform for better wrapping. The left clamping jaw 6 is of the electromagnetic suction type, which clamps by electromagnetic suction.

The process here is as follows:
setting two stations, wherein the left side is the first station and the right side is the second station; pulling out the composite adhesive tape by the right clamping jaw 7, to the width of one station plus the length of the electrode; cutting off the composite adhesive tape by the interconnect wire cutter 2, with adhesive tape sheets underneath, placing on the first station; taking the first cell piece by the manipulator from one side and placing on the pulled-out composite interconnect wire, pressing with the pressing cylinder 11, then moving to the right using the suction mechanism by one station;
pulling out the composite adhesive tape with a width of two cell pieces, with both ends of the interconnect wire not reaching the end portions of the two cell pieces, bending the middle to form a "Z" shape; again, taking the cell piece to the first station, pressing the cell piece at the first station by the pressing cylinder 11, and adhering the adhesive tape to the interconnect wire on the cell piece at the second station;
moving the cell pieces on the first station and second station to the right synchronously by the suction mechanism, then repeating the previous step; and
directly taking, for the last cell piece, an interconnect wire with a length of a width of one cell plus a length of one electrode, and performing adhesive applying and pressing.

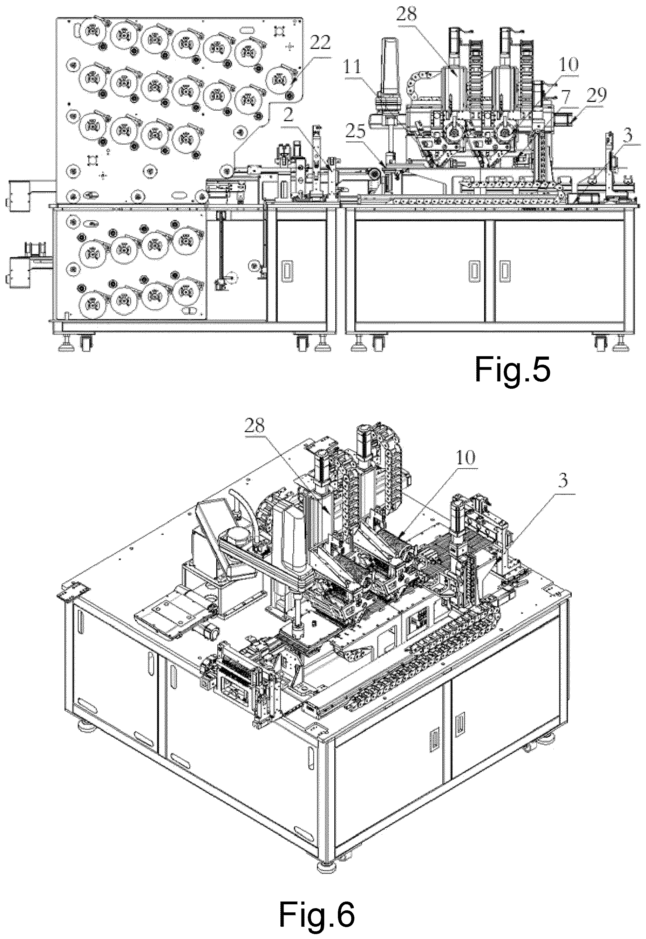

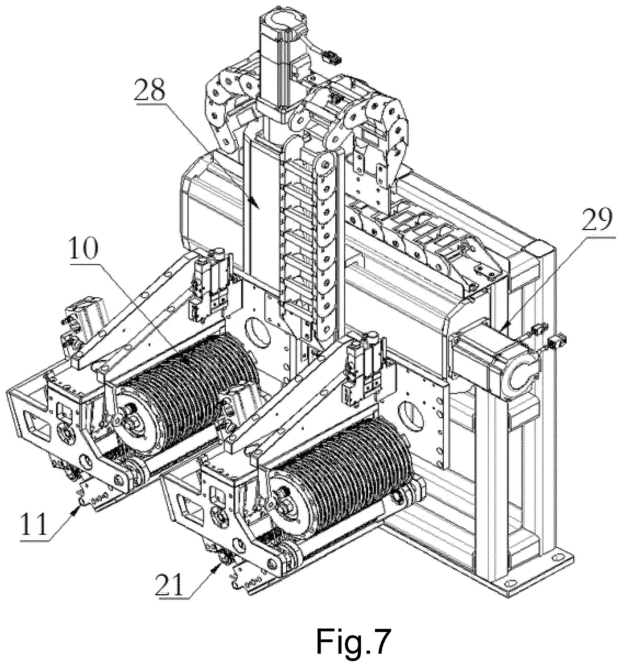

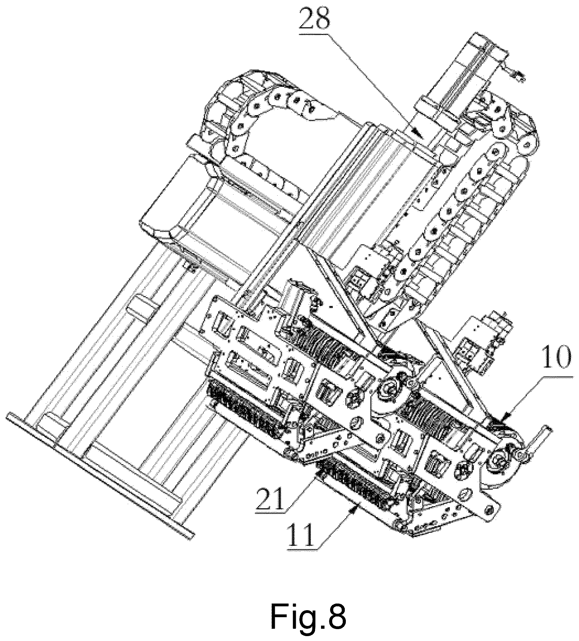

Referring to FIGS. 5 to 9, the photovoltaic stress-free interconnection device (or called cell upper-side wrapping mechanism) is provided in some other embodiments of the present invention. The photovoltaic stress-free interconnection device includes a workbench 3 and an interconnect wire disc 22 arranged at the left side of the workbench 3. The right side of the interconnect wire disc 22 is provided with an interconnect wire cutter 2, a left clamping jaw holding the cut interconnect wire, a right clamping jaw 7 pulling the interconnect wire to the right, and a suction mechanism moving the cell piece synchronously to the right. After the interconnect wire is cut off by the interconnect wire cutter 2, it is held by the left clamping jaw, then pulled tight by the right clamping jaw 7. The suction mechanism can move the cell piece synchronously to the right by one station. The suction mechanism includes a suction cup, a vertical lead screw motor moving the suction cup upwards, and a horizontal lead screw motor. The interconnect wire cutter 2 includes an interconnect wire blade and a cylinder driving the interconnect wire blade to move up and down.

The photovoltaic stress-free interconnection device further includes an adsorption mechanism mounted on the workbench 3 and configured for absorbing the adhesive tape, and a wrapping mechanism adhering the adhesive tape from the upper side to the cell piece. The wrapping mechanism can pull out two types of adhesive tapes, one with the adhesive side down and the other with the adhesive side up. The adsorption mechanism is configured to fix the adhesive tape with the adhesive side up, thus avoiding the need to adhere to the adhesive tape from below. This reduces the complexity of the process.

The adsorption mechanism includes a plate body 25 with a hollow inner cavity and adsorption holes 26 evenly arranged on an upper end of the plate body 25, wherein a lower end of the plate body 25 is connected to a negative pressure pipeline. The negative pressure pipeline controls the suction of the plate body 25.

The wrapping mechanism includes two rollers 10 wound by adhesive tapes, which are located on the upper side of the workbench, such as the left and right rollers. The adhesive surfaces of the adhesive tapes on the two rollers 10 are opposite. One side of the roller 10 is provided with an adhesive tape cutter, wherein the adhesive tape cutter includes an adhesive tape blade and a cylinder driving the adhesive tape blade to move up and down. The wrapping mechanism further includes a power mechanism driving the roller 10 to move up and down and left and right. The power mechanism includes a vertical cylinder 28 capable of moving and telescoping vertically, and a horizontal cylinder 29 connected to the vertical cylinder 28 and capable of telescoping horizontally. The roller 10 is mounted on a telescopic end of the horizontal cylinder 29. Two horizontal cylinders 29 and two vertical cylinders 28 are included here, with one vertical cylinder 28 combined with one horizontal cylinder 29 to achieve up-and-down and left-and-right movements, thereby achieving the adhesion of the adhesive tape. In addition, the vertical cylinder in the embodiment can be replaced by a vertical electric push rod, and/or the horizontal cylinder can be replaced by a horizontal electric push rod.

The wrapping mechanism also includes a pressing mechanism pressing the adhesive tape adhered, thus making the adhesion of the adhesive tape stronger after adhering. The pressing mechanism includes a pressing cylinder 11 parallel to the roller 10, which is mounted on the left side of the roller 10 in a manner of rotating. The pressing cylinder 11 is configured for pressing the cell piece after the composite interconnect wire is adhered. The adhesive tape cutter is located on the left side of the pressing cylinder 11. A secondary rolling mechanism is arranged on the left side of the pressing cylinder 11. The secondary rolling mechanism includes a pressing ring 21 pressing the adhesive tape, which is arranged on the left side of the pressing cylinder 11. The number of pressing rings 21 corresponds to the number of adhesive tapes; here, the adhesive tape can also be a whole piece. Multiple pressing rings 21 are provided, and the number of pressing rings corresponds to that of the adhesive tapes. The workbench 3 here is provided with a processor, with each electric component correspondingly connected to the processor for unified control.

The process flow here is as follows:
fixing the lower adhesive tape, wherein the plate body 25 is set as the first station, with the right side of the plate body 25 as the second station; firstly, the roller 10 on the left side lays the adhesive tape with the adhesive side up on the plate body 25; and the plate body 25 starts to suction so as to fix the adhesive tape;
laying the first cell, wherein the right clamping jaw 7 pulls the interconnect wire to the right with a length of one station plus a length of an electrode; cutting by the interconnect wire cutter 2 and then clamped by the left clamping jaw, the interconnect wire is laid on the adhesive tape on the upper side of the plate body 25; next, the manipulator on the side of the interconnect wire disc 22 takes the cell piece from the conveyor belt and places it on the laid interconnect wire; and the plate body 25 blows air, the suction mechanism moves the first cell piece to the right to the second station, and the aforementioned step of fixing the lower adhesive tape is performed;
laying the cell, wherein, next, the right clamping jaw 7 grabs the interconnect wire whose length is the length of two stations, the middle of the interconnect wire is bent to form a "Z" shape and both ends do not reach the end portions; and the manipulator on the side of the interconnect wire disc 22 takes the cell piece from the conveyor belt and places it on the laid interconnect wire; and
laying the upper adhesive tape, wherein the roller 10 on the right side adheres the adhesive tape on the interconnect wire at the second station; the adhesive tape cutter cut off the adhesive tape, and the pressing cylinder 11 presses it tightly; then the cell pieces on the first station and the second station are moved synchronously to the right by the suction mechanism; and
performing repeatedly the step of fixing the lower adhesive tape, the step of laying the cell, and the step of laying the upper adhesive tape.

In the device provided in the embodiments of the present invention, the workbench 3 is provided with two rollers 10, thereby achieving the adhesion of the adhesive tape from the upper side and effectively avoiding the adhesion of the adhesive tape from the lower side. This lowers the process difficulty. Additionally, by using the plate body 25 for suction, the effect of fixation achieved is better.

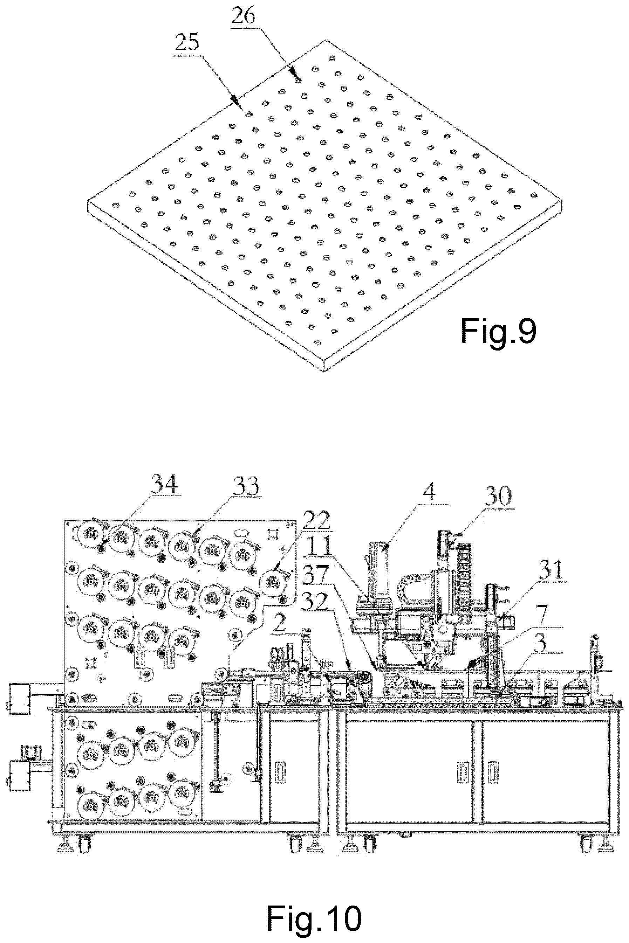

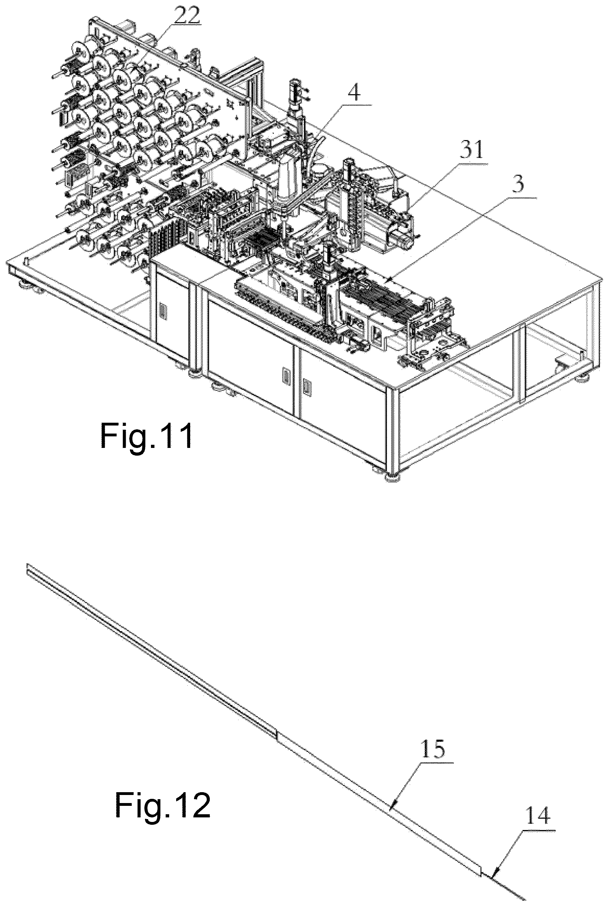

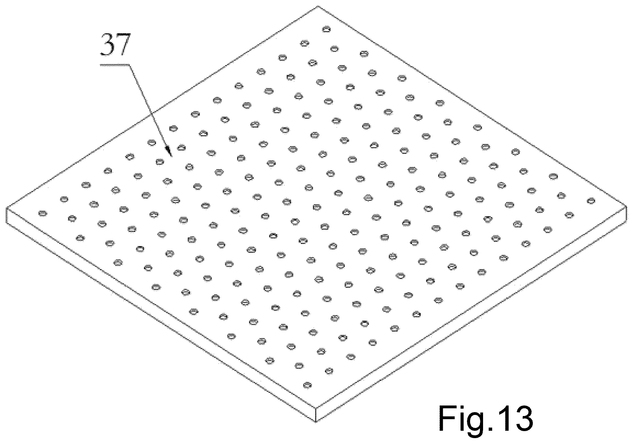

Referring to FIGS. 10 to 14, the photovoltaic stress-free interconnection device (or called double-sided solder-strip cell wrapping mechanism) is provided by some then the embodiments of the present invention. The photovoltaic stress-free interconnection device includes a workbench 3; an interconnect wire disc 22, which is arranged on the left side of the workbench 3 and wound by the composite interconnect wire; and a manipulator 4 feeding the material. The manipulator 4 can move up and down, and can rotate. The gripping end of the manipulator 4 is provided with a negative suction cup. The right side of the interconnect wire disc 22 is provided with an interconnect wire cutter 2, a left clamping jaw holding the cut interconnect wire, a right clamping jaw 7 pulling the interconnect wire to the right, and a suction mechanism moving the cell piece synchronously to the right. The suction mechanism can drive the cell pieces to move to the right synchronously. The interconnect wire cutter 2 includes a cylinder and a blade connected to the end of the cylinder. The right clamping jaw 7 can be electromagnetic or mechanical and is connected by an electric push rod or cylinder capable of moving to the right.

The composite interconnect wire includes an interconnect wire and adhesive tapes arranged at equal intervals along a length direction of the interconnect wire on both opposite sides of the interconnect wire. Two adjacent adhesive tapes 15 are alternately arranged on both sides of the interconnect wire 14, and the adhesive surfaces of the adjacent adhesive tapes 15 are opposite. In other words, along the length direction of the interconnect wire, the two adjacent adhesive tapes are alternately arranged on both opposite sides of the interconnect wire, and the adhesive surfaces of the two adjacent adhesive tapes are opposite in a direction transverse to the length direction. The inner and outer adhesive tapes 15 can be connected by release paper. In other words, the adjacent inner-ring adhesive tapes and outer-ring adhesive tapes of the composite interconnect wire, wound on the interconnect wire disc, can be connected by release paper. One side of the interconnect wire disc 22 is arranged with a pressing plate 33 closely abutting the composite adhesive tape in an elastic manner. A release film is arranged at an end of the pressing plate 33 in contact with the adhesive tape 15. This avoids the loosening of the composite interconnect wire. The device further includes a release paper winding mechanism arranged on one side of the interconnect wire disc 22, so as to collect the release paper. The winding mechanism includes a winding drum 34 and a motor connected to the winding drum 34, which drives the winding drum 14 to rotate and wind through the motor.

The device further includes an adsorption mechanism mounted on the workbench 3 and configured for absorbing the adhesive tape, and a pressing mechanism pressing, from the upper side, the cell to which the composite adhesive tape is adhered. The adsorption mechanism is the first station, and the left end of the workbench is the second station, close to the right side of the first station.
The adsorption mechanism includes a plate body 37 with a hollow inner cavity and adsorption holes evenly arranged on an upper end of the plate body 37, wherein a lower end of the plate body 7 is connected to a negative pressure pipeline. This enables suction and blowing through a negative pressure pipeline.

The wrapping mechanism, which includes the pressing cylinder 11 configured for pressing and does not include the roller 10 configured for applying the adhesive tape, and therefore can also be called a pressure mechanism or a pressing mechanism, includes a pressing cylinder 11 and a power mechanism that drives the pressing cylinder 11 to move up and down and left and right. The power mechanism driving the pressing cylinder 11 to move up and down and left and right. The power mechanism includes a vertical electric push rod 30 capable of telescoping up and down, and a horizontal electric push rod 31 mounted on a telescopic end of the vertical electric push rod 30. The pressing cylinder 11 is mounted on the telescopic end of the horizontal electric push rod 31 in a rotating manner. The electric push rod here can also be a cylinder. The left clamping jaw can be mechanical or magnetic, as long as it can grip the cut interconnect wire.

The device also includes a support plate 32 that can move up and down and left and right, which is arranged between the interconnect wire disc 22 and the right manipulator 4. An interconnect wire groove is arranged on the support plate 32. The left clamping jaw is mounted at the right end of the interconnect wire groove. Movement of the support plate 32 can be achieved by a combination of cylinders that telescope up and down, left and right. By arranging the support plate 32, the operation of the composite interconnect wire on the left side can be facilitated.

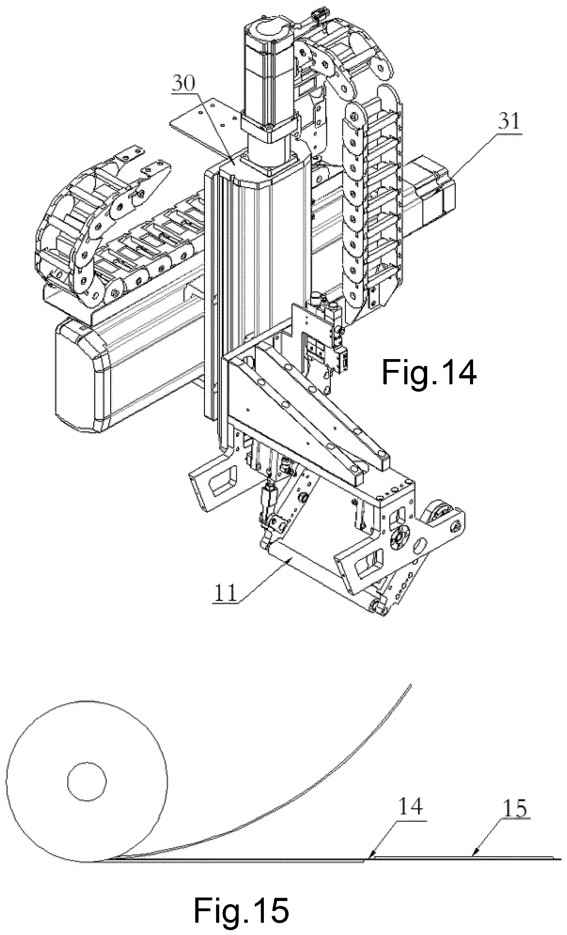

As shown in FIG. 15, after the composite interconnect wire is wound, its inner and outer adhesive tapes are connected by the release paper to avoid bonding.

The specific process flow is as follows:
laying a first cell piece, wherein the right clamping jaw 7 pulls the composite interconnect wire to the right by one station, places it on the plate body 37, which is the first station, adds one electrode length; the adhesive surface of the adhesive tape 15 faces up; the plate body 37 sucks air and the solder tape is cut off by the interconnect wire cutter 2; the left clamping jaw clamps tightly, the manipulator 4 takes the cell piece 13 from the conveyor belt and puts it on the laid composite interconnect wire; the pressing cylinder 11 rolls and then returns; the plate body 37 blows air, and the suction mechanism moves the first cell piece 15 to the right to the second station.
pressing the cell piece, wherein the right clamping jaw 7 grabs the interconnect wire whose length is the length of two cell pieces 13, and the middle is bent to form a "Z" shape; the right side is laid on the cell piece 13 at the second station, the adhesive side of the adhesive tape 15 on the right side is downward, which is absorbed by the plate body 37; then, the manipulator 4 takes a cell piece 13, places it at the first station, and moves away; the pressing cylinder 11 rolls, the plate body 37 blows air, and the suction mechanism moves all the cell pieces 13 to the right by one station;
repeating the step of pressing the cell piece.

In the device provided in the embodiments of the present invention, the composite interconnect wire includes an interconnect wire 14 and adhesive tapes 15 arranged on the front and back surfaces of the interconnect wire 14, thus eliminating the need for adhering the adhesive or wrapping and allowing direct pressing. This simplifies the process and reduces costs.

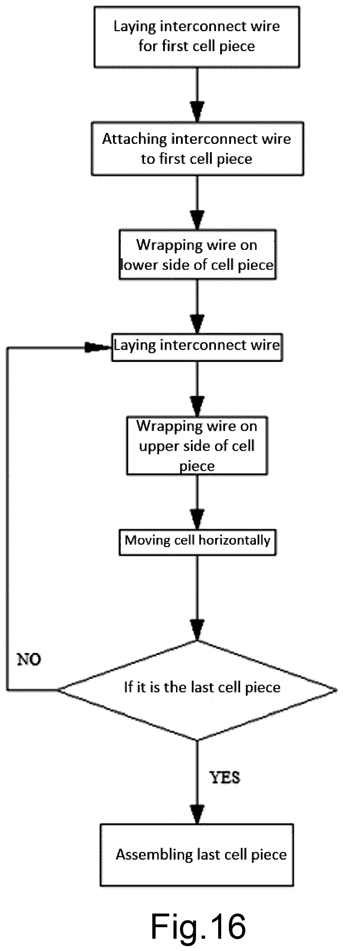

As shown in FIG. 16, some embodiments of the present invention provide a use method for a photovoltaic stress-free interconnection device, comprising the following steps:
laying an interconnect wire for a first cell piece, wherein the right clamping jaw 7 pulls the interconnect wire in the left clamping jaw 6 to the right, wherein a length is a width of one cell piece plus a length of an electrode, for easy connection; at the same time, the left end of the interconnect wire is a little less to the edge of the cell; cutting by the interconnect wire cutter 2 and then clamped by the left clamping jaw 6, such that the interconnect wire is straightened;
attaching the interconnect wire to the first cell piece, wherein a manipulator 4 transfers the first cell piece from a conveyor belt to an overhanging frame on a left side of a workbench 3, which is a first station, and the first cell piece is pressed downwards to contact the interconnect wire on the lower side;
performing wrapping on the lower side of the cell piece, wherein the lower roller 10 moves upwards, the interconnect wire is fixed to the cell piece with adhesive tape, and the adhesive tape is affixed from right to left; then, the left clamping jaw 6 releases the interconnect wire, the support plate 8 moves to the left, and the roller 10 continues to move; after affixing, the adhesive tape is cut by the adhesive tape cutter 12, the roller 10 returns to an initial position, the support plate 8 returns to an initial position, the left clamping jaw 6 releases, and the manipulator 4 moves away;
placing the cell piece, wherein a suction device 5 moves the cell piece to the right onto the workbench 3, which is a second station;
laying the interconnect wire, wherein the right clamping jaw 7 grabs the interconnect wire and moves it to the right, then the interconnect wire cutter 2 cuts the interconnect wire to a length corresponding to a distance between the first station and the second station; a left end of the interconnect wire does not reach a left end of the cell, making it easy to leave a distance, and a right end does not reach a right end of the right cell, also making it easy to leave a distance; there will be a bend in the center to form a "Z" shape, making it easier to connect the two batteries; therefore, a length of the right clamping jaw 7 grip for gripping corresponds to the length and can be adjusted in practice as required; then the left clamping jaw 6 clamps tightly and the interconnect wire is straightened, wherein a right-side part of the interconnect wire is located on the upper side of the cell piece in the second station; then the manipulator 4 again takes the cell piece and places it in the first station and on the upper side of the interconnect wire;
performing wrapping on the upper side of the cell piece, wherein the upper roller 10 adheres the adhesive tape to the upper side of the cell piece at the second station; the roller 10 moves to the left, then down and to the right after the adhesive tape has been adhered; when approaching the tail portion of the cell piece, the right clamping jaw 7 releases and moves to the right to avoid; after the adhesion is completed, the adhesive tape is cut off by an adhesive tape cutter 12, and the above step of performing wrapping on the lower side of the cell piece is repeated;
moving the cell horizontally, wherein the suction device 5 moves the cell pieces from the first station and second station to the right by one station, then the above step of laying the interconnect wire continues and the subsequent steps are performed, cycling until the set last cell piece is reached; and
assembling the last cell piece, wherein, after attaching the adhesive tape to the lower side of the last cell piece at the first station, the manipulator 4 moves away; under the action of the suction device 5, the cell piece on its right side is moved to the right by one station and then reaches the second station, and the suction device 5 moves away; the right clamping jaw 7 pulls an interconnect wire with a length of one station plus a length of an electrode; the interconnect wire cutter 2 cuts the interconnect wire, the left clamping jaw 6 clamps tightly, and the support plate 8 and the right clamping jaw 7 move to the right together, so as to adhere the interconnect wire to the surface of the cell; the upper roller 10 adheres the adhesive tape to the upper side of the cell piece at the second station; the roller 10 moves to the left, then down and to the right after the adhesive tape has been adhered; when approaching the tail portion of the cell piece, the right clamping jaw 7 releases and moves to the right to avoid; after the adhesion is completed, the adhesive tape is cut off by an adhesive tape cutter 12.

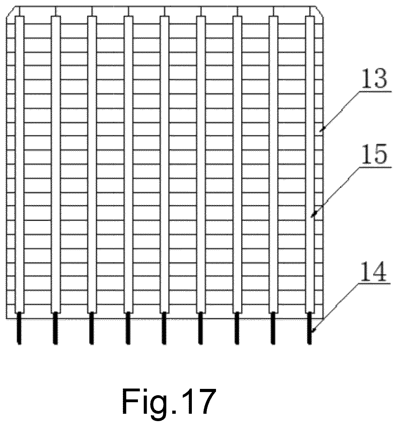

As shown in FIG. 17, some embodiments of the present invention provide an assembly produced by the use method for the above photovoltaic stress-free interconnection device. The assembly comprises a cell piece 13, an interconnect wire 14 arranged on the cell piece 13, and an adhesive tape 15 fixing the interconnect wire 14 to the cell piece 13. The adhesive tape 15 wraps around the interconnect wire 14 from the outside and is fixed to the cell piece 13.

Although embodiments of the present invention have been illustrated and described, it is understood that those ordinarily skilled in the art can make various changes, modifications, substitutions, and variations to these embodiments without departing from the principles and spirit of the present invention. The scope of the present invention is defined by the appended claims and their equivalents.

### Industrial Practicality

The embodiments of the present invention provide a photovoltaic stress-free interconnection device, a use method, and a produced assembly. The photovoltaic stress-free interconnection device includes a body. An interconnect wire disc (interconnect wire coil) configured for releasing the interconnect wire is arranged on the left side of the body. An interconnect wire cutter cutting the interconnect wire is arranged on the upper side of the interconnect wire disc. A feeding mechanism configured for transmitting the cell pieces is arranged on one side of the interconnect wire cutter, and a workbench configured for placing the cell pieces is arranged on the body. A conveying mechanism moving the cell pieces to the right is arranged on the workbench. A drawing mechanism that pulls out and wraps the interconnect wire on the cell pieces, and a wrapping mechanism that fixes the interconnect wire on the cell pieces are further included. The device provided by the embodiments of the present invention achieves the fixation of the interconnect wire and the adhesive tape, thereby integrating processing, and improving efficiency. Interconnection at normal temperature avoids cell warping and prevents cell piece fragments caused by uneven temperature, thus improving the yield rate; normal temperature interconnection avoids the power consumption caused by infrared welding, thus saving costs. Using stress-free interconnection technology, flux is no longer used, thus reducing costs, improving reliability, and being more environmentally friendly.

Additionally, it is important to note that the photovoltaic stress-free interconnection device, the use method, and the produced assembly provided in the embodiments of the present invention are reproducible and applicable in various industrial applications. For example, the photovoltaic stress-free interconnection device, the use method, and the produced assembly provided in the embodiments of the present invention can be applied in the field of photovoltaic power generation.

## Claims

1. A photovoltaic stress-free interconnection device, comprising a body (1), **characterized in that** an interconnect wire coil (22) configured for releasing an interconnect wire is arranged on a left side of the body (1); an interconnect wire cutter (2) cutting the interconnect wire is arranged on an upper side of the interconnect wire coil (22); a feeding mechanism configured for transmitting cell pieces is arranged on one side of the interconnect wire cutter (2), and a workbench (3) configured for placing the cell pieces is arranged on the body (1); a conveying mechanism moving the cell pieces to the right is arranged on the workbench (3); and
further comprising a drawing mechanism that pulls out and wraps the interconnect wire on the cell pieces, and a wrapping mechanism that fixes the interconnect wire on the cell pieces.

2. The photovoltaic stress-free interconnection device according to claim 1, wherein the interconnect wire is a composite interconnect wire, and the composite interconnect wire is formed by the interconnect wire and an adhesive tape arranged on the interconnect wire.

3. The photovoltaic stress-free interconnection device according to claim 2, wherein multiple adhesive tapes are arranged at equal intervals on a side of the interconnect wire, and the adhesive tapes are adhered to the interconnect wire through adhesive surfaces, with a spacing between two adjacent adhesive tapes corresponding to a width of the cell pieces.

4. The photovoltaic stress-free interconnection device according to claim 2, wherein the composite interconnect wire comprises the interconnect wire and the adhesive tapes arranged at equal intervals along a length direction of the interconnect wire on both opposite sides of the interconnect wire; along the length direction of the interconnect wire, two adjacent adhesive tapes are alternately arranged on the both opposite sides of the interconnect wire, and adhesive surfaces of the two adjacent adhesive tapes are opposite in a direction transverse to the length direction.

5. The photovoltaic stress-free interconnection device according to claim 4, wherein adjacent inner-ring adhesive tapes and outer-ring adhesive tapes of the composite interconnect wire, wound on the interconnect wire coil, are connected by a release paper.

6. The photovoltaic stress-free interconnection device according to any one of claims 1 to 5, wherein the feeding mechanism is a manipulator (4) capable of rotating and moving up and down and provided with a first suction cup at a lower end.

7. The photovoltaic stress-free interconnection device according to any one of claims 1 to 6, wherein the conveying mechanism comprises a suction device (5) capable of driving the cell pieces to move up and down and left and right, and multiple second suction cups are arranged at a lower end of the suction device (5).

8. The photovoltaic stress-free interconnection device according to any one of claims 1 to 7, wherein the drawing mechanism comprises a left clamping jaw (6) arranged on a right side of the interconnect wire coil (22), and a right clamping jaw (7) arranged on the right side of the interconnect wire coil (22) and capable of moving up and down and left and right; the interconnect wire is pulled out and straightened by the right clamping jaw (7) after passing through inside of the left clamping jaw (6); and the right clamping jaw (7) is mounted on the body (1).

9. The photovoltaic stress-free interconnection device according to claim 8, wherein a support plate (8) capable of moving left and right and up and down is arranged between the interconnect wire coil (22) and the right clamping jaw (7); the support plate (8) is provided with a guide groove (9) guiding the interconnect wire; and the left clamping jaw (6) is mounted on an end portion of the guide groove (9).

10. The photovoltaic stress-free interconnection device according to claim 1, wherein the wrapping mechanism comprises two rollers (10) that can move up and down, left and right, and rotate, with the adhesive tapes wound around; an upper side and a lower side of the workbench (3) are respectively arranged with the rollers (10); a pressing cylinder (11), parallel to the rollers (10) and configured for pressing the adhesive tapes, is further arranged on a left side of the rollers (10); the workbench (3) extends to the left to form an overhanging frame that supports front and rear sides of a bottom of the cell pieces; and the wrapping mechanism is further provided with an adhesive tape cutter (12) configured for cutting off the adhesive tapes.

11. The photovoltaic stress-free interconnection device according to any one of claims 2 to 3, wherein the wrapping mechanism comprises a roller (10) arranged on the body (1) and wound by the adhesive tapes and capable of moving left and right and up and down; and a support frame configured for supporting the roller (10); a pressing cylinder (11) capable of moving up and down is further mounted at a left side of the roller (10) on the support frame; and an adhesive tape cutter (12) capable of cutting off the adhesive tapes is further arranged on the support frame.

12. The photovoltaic stress-free interconnection device according to claim 10 or 11, wherein the wrapping mechanism comprises two pressing cylinders (11), and the adhesive tape cutter (12) is located between the two pressing cylinders (11).

13. The photovoltaic stress-free interconnection device according to claim 12, wherein a pressing cylinder (11) of the two pressing cylinders (11), which is relatively remote from the interconnect wire coil in a longitudinal extension direction of the body (1), is made of a rubber material with elasticity, so as to press the adhesive tapes against the support frame.

14. The photovoltaic stress-free interconnection device according to any one of claims 1 and 4, wherein the wrapping mechanism comprises left and right rollers (10) wound by adhesive tapes, and adhesive surfaces of the adhesive tapes on the two rollers (10) are opposite; the wrapping mechanism further comprises a power mechanism driving the rollers (10) to move up and down and left and right, and a pressing cylinder (11) mounted on a left side of the rollers (10) in a manner of rotating; and an adhesive tape cutter is located on a left side of the pressing cylinder (11).

15. The photovoltaic stress-free interconnection device according to claim 14, wherein the power mechanism comprises a vertical cylinder (28) capable of moving and telescoping up and down and a horizontal cylinder (29) connected to the vertical cylinder (28) and capable of telescoping horizontally; and the rollers (10) are mounted on a telescopic end of the horizontal cylinder (29).

16. The photovoltaic stress-free interconnection device according to any one of claims 14 to 15, wherein a secondary rolling mechanism is arranged on a left side of the pressing cylinder (11).

17. The photovoltaic stress-free interconnection device according to claim 16, wherein the secondary rolling mechanism comprises a pressing ring (21) arranged on the left side of the pressing cylinder (11) and pressing the adhesive tapes.

18. The photovoltaic stress-free interconnection device according to claim 17, wherein multiple pressing rings (21) are provided, and the number of the pressing rings (21) corresponds to that of the adhesive tapes.

19. The photovoltaic stress-free interconnection device according to claim 4 or 5, wherein the wrapping mechanism comprises a pressing cylinder (11) and a power mechanism driving the pressing cylinder (11) to move up and down and left and right.

20. The photovoltaic stress-free interconnection device according to claim 19, wherein the power mechanism comprises a vertical electric push rod (30) capable of telescoping up and down, and a horizontal electric push rod (31) connected to the vertical electric push rod (30) and capable of telescoping horizontally; and the pressing cylinder (11) is mounted on a telescopic end of the horizontal electric push rod (31).

21. The photovoltaic stress-free interconnection device according to claim 10, wherein an adhesive tape groove guiding the adhesive tapes is arranged on the rollers (10) along a circumferential direction of the roller (10).

22. The photovoltaic stress-free interconnection device according to any one of claims 4 to 5, wherein the photovoltaic stress-free interconnection device further comprises an adsorption mechanism mounted on the workbench (3) and configured for absorbing the adhesive tapes.

23. The photovoltaic stress-free interconnection device according to claim 22, wherein the adsorption mechanism comprises a plate body (25) with a hollow inner cavity and adsorption holes (26) evenly arranged on an upper end of the plate body (25); and a lower end of the plate body (25) is connected to a negative pressure pipeline.

24. The photovoltaic stress-free interconnection device according to claim 4 or 5, wherein a side of the interconnect wire coil (22) is arranged with a pressing plate (33) closely abutting the composite interconnect wire in an elastic manner; and a release film is arranged at an end of the pressing plate (33) in contact with the adhesive tapes.

25. The photovoltaic stress-free interconnection device according to claim 5, wherein the photovoltaic stress-free interconnection device further comprises a release paper winding mechanism arranged on a side of the interconnect wire coil (22).

26. The photovoltaic stress-free interconnection device according to claim 25, wherein the release paper winding mechanism comprises a winding drum (34) and a motor connected to the winding drum (34).

27. A use method for the photovoltaic stress-free interconnection device according to any one of claims 1 and 6 to 10, **characterized by** comprising following steps:
laying the interconnect wire for a first cell piece, wherein a right clamping jaw (7) pulls the interconnect wire in a left clamping jaw (6) to the right, wherein a length is a width of one cell piece plus a length of an electrode; cutting by an interconnect wire cutter (2) and then clamped by the left clamping jaw (6), such that the interconnect wire is straightened;
attaching the interconnect wire to the first cell piece, wherein a manipulator (4) transfers the first cell piece from a conveyor belt to an overhanging frame on a left side of a workbench (3), which is a first station, and the first cell piece is pressed downwards to contact the interconnect wire on a lower side;
performing wrapping on a lower side of a cell piece, wherein a lower roller (10) moves upwards, the interconnect wire is fixed to the cell piece with adhesive tapes, and the adhesive tapes are affixed from right to left; then, the left clamping jaw (6) releases the interconnect wire, a support plate (8) moves to the left, and the roller (10) continues to move; after affixing, the adhesive tapes are cut by an adhesive tape cutter (12), the roller (10) returns to an initial position, the support plate (8) returns to an initial position, the left clamping jaw (6) releases, and the manipulator (4) moves away;
placing the cell piece, wherein a suction device (5) moves the cell piece to the right onto the workbench (3), which is a second station;
laying the interconnect wire, wherein the right clamping jaw (7) grabs the interconnect wire and moves to the right, then the interconnect wire cutter (2) cuts the interconnect wire to a length corresponding to a distance between the first station and the second station; the left clamping jaw (6) clamps tightly and the interconnect wire is straightened,
wherein a right-side part of the interconnect wire is located on an upper side of the cell piece in the second station; then the manipulator (4) again takes the cell piece and places the cell piece in the first station and on an upper side of the interconnect wire;
performing wrapping on an upper side of the cell piece, wherein an upper roller (10) adheres the adhesive tape to the upper side of the cell piece at the second station; the roller (10) moves to the left then down, and to the right after the adhesive tape has been adhered; when approaching a tail portion of the cell piece, the right clamping jaw (7) releases and moves to the right to avoid; after the adhesion is completed, the adhesive tape is cut off by the adhesive tape cutter (12), and the step of performing wrapping on a lower side of the cell piece is repeated;
moving a cell horizontally, wherein the suction device (5) moves the cell pieces from the first station and the second station to the right by one station, then the step of laying the interconnect wire continues and subsequent steps are performed, cycling until a set last cell piece is reached; and
assembling the last cell piece, wherein, after attaching the adhesive tape to a lower side of the last cell piece at the first station, the manipulator (4) moves away; under an action of the suction device (5), the cell piece on a right side is moved to the right by one station and then reaches the second station, and the suction device (5) moves away; the right clamping jaw (7) pulls the interconnect wire with a length of one station plus a length of an electrode; the interconnect wire cutter (2) cuts the interconnect wire, the left clamping jaw (6) clamps tightly, and the support plate (8) and the right clamping jaw (7) move to the right together, so as to adhere the interconnect wire to a surface of the cell; the upper roller (10) adheres the adhesive tape to the upper side of the cell piece at the second station; the roller (10) moves to the left then down, and to the right after the adhesive tape has been adhered; and when approaching the tail portion of the cell piece, the right clamping jaw (7) releases and moves to the right to avoid; and after the adhesion is completed, the adhesive tape is cut off by the adhesive tape cutter (12).

28. An assembly produced by the photovoltaic stress-free interconnection device according to any one of claims 1 to 26, **characterized in that** the assembly comprises a cell piece (13), an interconnect wire (14) arranged on an upper side and a lower side of the cell piece (13), and an adhesive tape (15) fixing the interconnect wire (14) to the cell piece (13).
